# EUROPEAN PATENT APPLICATION

(11) **EP 3 460 451 A2**
(43) Date of publication of application: **27.03.2019**
(21) Application number: 18192106.5
(22) Date of filing: 31.08.2018
(51) Int. Cl.: G01N 17/04, G01N 29/04

(54) **INTEGRITY MONITORING SPOOL**

(30) Priority: 31.08.2017 US 201715692587
(71) Applicant: Teledyne Limited, Middlesex UB7 0LQ (GB)
(72) Inventor: CLARKE, Daniel, Brighton, East Sussex BN41 1AX (GB)
(74) Representative: Carter, Stephen John

(57) **Abstract**

The present invention relates to an integrity monitoring spool system and apparatus. The system and apparatus brings different types of sensors together in a single forging or pipeline spool with one common electronics module for all the sensors which facilitates additional subsea processing using data comparisons across devices to enhance the quality and accuracy of the data reported. The common electronics module includes individual sensor measurement electronics circuits which connect directly to the individual sensors transducers and pass excitation and measurement signals to and from one another via signal wires inside high pressure metal tubing. Furthermore, by combining the data from the different intrusive and non-intrusive sensors in one common electronics module and processing the data subsea in real-time, the accuracy and quality of the sensor data can be greatly enhanced by comparing, cross-checking, combining and processing data from the various different sensors subsea in real-time.

## Description

### Field of the Invention

The present invention relates to an apparatus and system for monitoring and measuring data from multiple different active and comparator sensors and processing the subsea data from these sensors in real time and in one common electronics module. Such an apparatus and system may be used to monitor and characterize the flow through oil or gas pipelines. In particular, the combined impact of corrosion, erosion, pressure and temperature variations and extremes, and sand may be monitored and characterized in real-time. The system and apparatus facilitates additional subsea processing using data comparisons across devices to enhance the quality and accuracy of the data reported.

### Background of the Invention

The deleterious effects, and resulting technical and commercial threats, posed by solids (e.g. sand), and the corrosivity of fluids traveling in oil and gas pipes as produced from the reservoir formation are well known to oil and gas operating companies and asset managers. Proactive strategies are required to manage the negative impacts of these solids and corrosive fluids on production and to maximise operational productivity. Solids production is typically episodic and can cause extreme damage almost instantaneously. Corrosive fluids can also be episodic due to water breakthrough. The consequences can include reservoir damage, erosion of choke valves, erosion and accelerated corrosion of pipework, reduction of corrosion inhibitor performance and the filling of separators: all resulting in reduced productivity and potential failure. What is needed is a collection of critical information in near real-time related to unwanted solids and other infiltration to promote timely and effective management of solids and other infiltration in offshore and subsea systems.

Corrosion and erosion sensors are used in the detection and monitoring of loss of material, such as the internal surface of a pipeline wall, due to corrosion and/or erosion from interaction between the material and the environment in contact with the material. Such conditions exist in oil or gas pipelines.

At present a number of independent discrete sensors are used to monitor corrosion, erosion and sand individually in oil and gas pipelines. The various sensors are often provided by different manufacturers, and the measurements taken by different sensors are not easily correlated. Commonly, corrosion sensors use electrical resistance methods to detect loss of material due to corrosion/erosion. Such sensors are described, for example, in U.S. Pat. No. 6946855, U.S. Pat. No. 6680619, U.S. Pat. No. 6680619, U.S. Pat. Publ. 2011/001498, WO01/70003, WO02/39102, WO2005/036152 and WO8303675 and further relevant prior art is described in US Patent No. 7,878,047 (Hemblade) and US Patent Application No. 2010/0326654 (Hemblade), WO 00/63674, US 6693445, GB 2347748B, GB 2349221B, US 9228867, GB 2800963 and GB 1943494.

In U.S. Pat. No 6946855, GB 2349221B and WO0063674 (Cormon Limited), the contents of which are hereby incorporated by reference in the entirety, an apparatus is disclosed for monitoring deleterious effects on a material of exposure to a fluid, and thereby monitoring the effect on a section of pipe for carrying the fluid. The apparatus includes a sensor element exposed to the fluid and formed as a ring of the material coaxially mounted within, but electrically insulated from, the section of pipe. Changes in the electrical resistance of the sensor element are monitored. Preferably, the apparatus also includes a reference element electrically insulated from the pipe, electrically connected in series to the sensor element and protected from exposure to the fluid. The elements may both be made from the same material as the pipe and, as they are contained within it, experience the same temperature and pressure variations as the pipe. In this manner a change in the resistance of the sensor element caused by corrosion/erosion by the fluid accurately indicates the degree of corrosion/erosion of the pipe carrying the fluid.

U.S. Pat. No 6680619 (Corrocean ASA) describes a sensor device for registering voltage drops on corrosion exposed structures. The sensor device is coupled to a surface area of the structure to which a voltage is supplied by electrodes causing an excitation current in that area. There are a plurality of sensors arranged in a matrix defining measurement points with defined distances, to obtain signals related to the voltage distribution in the surface area as a basis for determining material thickness and/or structure in the measurement area, thereby determining wall thickness and/or the occurrence of corrosion and/or erosion defects.

US Patent Application No. 2011/001498 (Roxar Flow Measurement AS) describes a method and device for monitoring a zone of a metal structure in terms of its electrical resistance in order to detect possible defects in the structure, by periodically passing current through the zone in different directions while measuring and recording voltage drops in a number of selected unit areas within the zone, and by combining, for each unit area, at least two measured values recorded during at least two measurements made with current passing in different directions, and by comparing values obtained by at least one similarly obtained value made earlier.

WO01/70003 (British Nuclear Fuels Plc) provides a method and apparatus aimed at improving the range of situations to which field signature method based techniques are applicable from measuring corrosion. In particular, WO01/70003 is directed towards situations in which the location requiring investigation has been the subject of pre-existing corrosion. WO01/70003 provides a method of investigating corrosion at a location, the method including providing a mounting unit for two or more electrical contacts, introducing the mounting unit to a replica of the location which has not corroded, measuring the voltage between the two or more electrical contacts at one or more times, the two or more electrical contacts being in contact with a replica of the location being investigated, introducing the mounting unit to the location which may have corroded, measuring the voltage between and/or the variation in the voltage between two or more electrical contacts at a first time and at one or more other times, the two or more electrical contacts being in contact with the location being investigated, passing a current through the replica location at the time of the voltage measurement and through the location at the time of the voltage measurements. The current is provided by a given source for the various voltage measurements. The voltage measurement for the replica location defines the characteristics for an uncorroded location. The voltage measurements for the location indicates the extent of corrosion which has occurred by the time of the first voltage measurement for the location and/or indicates the progress of corrosion between the first time and one or more of the other times of voltage measurement for the location.

In WO02/39102 (British Nuclear Fuels Plc), a method of monitoring or predicting corrosion using a field signature method is provided which is intended to be applicable to nonlinear locations, such as bends, junctions and the like. The method includes obtaining information on a relationship which links voltage measurements, obtained for a location, between two or more electrical contacts in contact with the location at a first time and one or more other times when a current is passed through the location, to the loss of material from the location. The information on the relationship is used in a modelling process which includes the generation of a model of the location, two or more points on that location and modelling the values generated for the voltages which will be measured between the two or more points with a current applied to the location at a first and at least at a second time. The model includes a change in configuration of the location between the first time and the second time so as to model loss of material from the location. The relationship has the expression of a relationship between a factor relating to the model voltage values and a factor relating to the change in configuration and/or location.

In WO2005/036152 (General Electric Company), a system and method for monitoring defects in a structure are provided. The system includes a power supply for supplying an electric current to a monitoring area of the structure and a reference. The system also includes a measurement circuit for measuring a potential drop across at least two contact points of the monitoring area and at least two contact points of the reference. The system also includes a processor adapted to determine a ratio of the monitoring area potential drop to the reference potential drop indicative of a percentage change in a thickness of the structure. The method includes the steps of supplying the current to the monitoring area and the reference; measuring a first potential drop across the monitoring area and the reference; and determining the ratio indicative of the percentage change in the thickness of the structure.

WO83/03675 (Sentralinstitutt For Industriell Forskning) relates to monitoring large structures to detect defects, e.g. cracks. An electric current is impressed on a steel structure equipped with contact points between which are measured voltage drops caused by the impressed current. A relatively large number of fixed contact points are used all over the area which is to be monitored. The voltage drops are measured between selected pairs of contact points and these voltage drops are compared with corresponding voltage drops having been measured previously in the same manner when the structure was in an initial condition, preferably without any defects. Such monitoring is mainly applicable on oil drilling rigs and petroleum production platforms for exploitation of oil and gas fields offshore, where it is important that the monitoring can be performed by means of robust and simple devices resistible to the prevailing rough environments.

In US Patent No. 7,878,047 and GB 1943494 (Cormon Limited), the contents of which are hereby incorporated by reference in the entirety, there is described an apparatus for monitoring particles in a fluid stream, comprising a body portion and a detector element that is acoustically decoupled from the body portion. The detector element comprises a target surface, a sample acoustic sensor and a corrosion sensor. The sample acoustic sensor is acoustically coupled to the target surface and is arranged to provide a first signal, which varies in dependence upon acoustic noise generated by impacts of particles and fluid on the target surface. The corrosion sensor is arranged to provide a second signal, which varies in dependence upon corrosion and/or erosion of the target surface. A corresponding method of monitoring particles in a fluid stream is also described. The method and apparatus are suitable for monitoring sand in oil and gas production flow streams.

In US Patent Publication No. 2010/0326654 (Teledyne Cormon Limited), the contents of which are hereby incorporated by reference in the entirety, an apparatus monitors a production flow from a gravel pack into a tubular sand screen disposed concentrically around downhole production tubing in an oil or gas well. A tubular sample layer is disposed concentrically around the sand screen to be exposed to the radial production flow in use. The sample layer is electrically insulated from the production tubing in use. An erosion sensor provides a signal which varies in dependence upon an electrical resistance of the sample layer, which is related to the erosion of the sample layer. An apparatus also monitors a substantially longitudinal production flow through downhole production tubing in an oil or gas well. A method and apparatus are used to monitor the condition of a gravel pack within an oil or gas well. Other methods monitor temperature or pressure conditions within an oil or gas well.

US Patent No. 6,693,445 and GB 2347748B (Sutton) discloses a probe which is suitable for use with an apparatus for monitoring the corrosion of a material by accurately measuring changes in the resistance of an exposed element in relation to a reference element. The two elements are electrically connected in series via a bridge. The elements are formed from the same piece of material divided along an elongate slot and are proximate to one another so that the temperature difference between them is kept to a minimum. This prevents false indications of corrosion by ensuring that the temperature coefficient of the resistivities is the same in both elements. The reference element is covered with a corrosion-resistant layer. This layer is preferably as thin as possible and also a good thermal conductor to further ensure equal temperature of the reference and exposed elements.

US Patent No. 9,228,867 (Teledyne Limited), the contents of which are hereby incorporated by reference in the entirety, describes an apparatus for characterising a flow through a conduit. The apparatus comprises a body portion, and first and second sensors. The body portion has a longitudinal axis extending between first and second body portion ends. The cross-sectional area of the body portion varies along the longitudinal axis. In use, the body portion is arranged to be disposed substantially longitudinally within the conduit with the first body portion end disposed upstream of the second body portion end. The first sensor is disposed at or near the first body portion end. The second sensor is longitudinally spaced from the first sensor. The body portion has a larger cross-sectional area at the second sensor than at the first sensor such that, in use, the second sensor experiences an accelerated flow as compared to the first sensor. The first and second sensors are operable to sense a common variable, thereby enabling the effects of accelerated flow on the common variable to be characterised.

GB 2800963 (Teledyne Limited), the contents of which are hereby incorporated by reference in the entirety, describes an apparatus for monitoring a conductive fluid conduit arranged to carry a fluid stream. The apparatus comprises a power supply, a plurality of electrical contact points connected to the fluid conduit, a voltage measurement device, and a processor. The power supply has a reference mode of operation and a sample mode of operation. In the reference mode of operation, the power supply is operable to supply an alternating electric current through the fluid conduit at a high frequency such that the current is confined near the surface of the fluid conduit due to the skin effect. In the sample mode of operation, the power supply is operable to supply an electric current through a full thickness of the fluid conduit. The voltage measurement device is operable to measure the voltage between pairs of said electrical contact points so as to obtain reference values of electrical resistance of the fluid conduit when the power supply is in the reference mode of operation and so as to obtain sample values of electrical resistance of the fluid conduit when the power supply is in the sample mode of operation. The processor is operable to modify the sample values of electrical resistance based on the corresponding reference values of electrical resistance so as to compensate for temperature variations. There is also described a corresponding method for monitoring a conductive fluid conduit arranged to carry a fluid stream.

What is needed is a system and apparatus that can compare data from multiple different subsea sensors in real time to provide better integrity signals and measurements. This will provide better consistency and accuracy among the different subsea sensors. Another known need is for a system and apparatus that can simultaneously compare, cross-check and correct data from all the sensors in real-time.

### Summary of the Invention

Embodiments described herein provide a new apparatus and system for monitoring and measuring data from different active and comparator sensors to process subsea data in real-time in one common electronics module.

The present invention will be able to acquire and fully process data subsea, where past methods relied upon unprocessed data being transmitted topsides, where such data checks and improvements would have to be implemented in the master control station or vendor software. This is not easy or practical to do, and requires high subsea bandwidth to transmit large quantities of diagnostic data. The present system and apparatus contains a re-calibration function that periodically outputs proposed coefficients (or re-confirms the existing coefficients) to the external control module, and these can be accepted or rejected by the Operator.

The present invention seeks to provide an improved monitoring system which does not require multiple standalone sensors with their own electronics housing, as the old methods and systems required. Rather than having discrete sensors positioned in multiple locations, each having their own electronics housing, the present invention brings all the sensors together in a single forging or pipeline spool with one common electronics module for all the sensors. This greatly reduces system costs and complexity, and facilitates additional subsea processing using data comparisons across devices to enhance the quality and accuracy of the data reported. The common electronics module includes individual sensor measurement electronics circuits which connect directly to the individual sensors transducers, which provide measurement signals for each sensor, which can then be read by the individual sensor measurement electronics circuits. The intrusive sensor assemblies no longer need to accommodate any electronics, and since they form a single installation, there is no requirement for an oil filled termination housing or connector interface. The overall package size and system complexity will therefore be greatly reduced, compared to multiple standalone sensors.

The present invention comprises an integrity monitoring spool system and apparatus, further comprising a common electronics module. Unlike current systems that install multiple standalone sensors each with their own electronics housing, the present invention has one common electronics module which aids in increasing efficiency and improving in terms of cost and space. Furthermore, by combining the data from the different intrusive and non-intrusive sensors in one common electronics module and processing the data subsea in real-time, the accuracy and quality of the sensor data can be greatly enhanced by comparing, cross-checking, combining and processing data from the various different sensors subsea in real-time.

According to a one configuration of the present invention, there is provided an integrity monitoring spool apparatus for monitoring and measuring data from different sensors to process subsea data in real-time. The apparatus comprises a body, a plurality of intrusive and non-intrusive sensors, means for transferring signals from each sensor or detector to a common electronics module, a common electronics module, and means for transferring power and communications to and from an external control module. The body portion of the integrity monitoring spool apparatus consists of a bore for carrying process fluids having a longitudinal axis extending between first and second body portion ends. The body being either a forging or a free-issue section of pipe. There are numerous process rated penetrations located throughout the body to support multiple intrusive sensors.

The first set of process rated penetrations on the body support multiple intrusive sensors comprising at least: one corrosion sensor, comprising a sensor head, sensor neck, sensor flange and sensor housing and located at or near the top of line of the body ("top of line corrosion sensor"), a second corrosion sensor, comprising a sensor head, sensor neck, sensor flange and sensor housing and located at or near the bottom of line of the body ("bottom of line corrosion sensor"), one comparator corrosion sensor, comprising a sensor head, sensor neck, sensor flange and sensor housing and located nearby the top and bottom of line corrosion sensors, for example at 3 o'clock, an erosion sensor, comprising a sensor head, sensor neck, sensor flange and sensor housing and located downstream the other sensors to prevent flow disturbance at the other sensor locations, a pressure and temperature sensor comprising a sensor head, sensor neck, sensor flange and sensor housing and located near the corrosion and erosion sensors to monitor for signs of drift in the corrosion and erosion sensor measurements, discussed in more detail herein below, and to display pressure and temperature measurements for cross-checking, and a non-intrusive acoustic sand detector located further downstream the erosion sensor comprising a detector head, a detector flange and a detector housing. All intrusive devices installed on the integrity monitoring spool will include single or dual barriers to process pressure with each barrier including a penetrator to permit electrical signals to pass through.

For all the sensors located on the integrity monitoring spool, the sensor head further comprises the transducer or transducers which provide measurement signals for each individual sensor when energized. The transducers in the top of line corrosion sensor, bottom of line corrosion sensor, and erosion sensor further comprise a sample and a reference element, where the reference element is fully protected from corrosion or erosion. The comparator corrosion sensor contains a sample and reference element identical to the active sensor elements, except that both are fully protected from corrosion. The sensor neck connects the sensor head to the sensor flange and sensor housing. The sensor flange provides the sealing interface to the body and is a structural component necessary for resisting pressure. The sensor housing provides an atmospheric cavity for feeding signal wires into the high-pressure metal tubing that connects the individual sensors to the common electronics module via individual feedthroughs located on the common electronics module. This sensor construction is well understood and anyone skilled in the art would be familiar with such sensors and their construction.

A second configuration of the integrity monitoring spool would be corrosion sensor specific and would only comprise a top of line corrosion sensor, a bottom of line corrosion sensor, a comparator corrosion sensor, a second top of line corrosion sensor, a second bottom of line corrosion sensor and a second comparator corrosion sensor. This configuration would solely detect top and bottom of line corrosion occurring in the body of the integrity monitoring spool. Each active corrosion sensor on the integrity monitoring spool again contains a reference and a sample element, where the reference element is fully protected from corrosion, for example by applying a ceramic coating. The comparator corrosion sensor comprises a reference element, which is fully protected from corrosion, but rather than comprising an unprotected sample element, the comparator corrosion sensor further comprises a sample element which is also fully protected from corrosion. The output of the comparator sensor may therefore be influenced by process related effects such as flow-rate, temperature and composition in precisely the same way as the active sensor is influenced, but will be independent of corrosion. In particular, the output of the comparator sensor will be governed by the temperature gradient that is established across the sample and reference elements for any given condition. Whilst that temperature gradient will probably be very small (for example, less than 1°C difference between hottest and coldest points), it can act to distort the corrosion measurement in the active sensors to a degree that is clearly observable. The output of the comparator sensor can be used to remove the effects of process-related noise seen in the active sensor measurements, thus increasing measurement accuracy and improving the effective measurement sensitivity. This compensation can be carried-out in the common electronics module by the active master processor in real-time.

Every sensor or device located on the integrity monitoring spool provides measurement signals and is connected to said common electronics module via high-pressure metal tubing. More specifically, the high-pressure metal tubing further comprises signal wires that carry the measurements signals provided by each sensor's transducer, located in the sensor head, and pass excitation and these measurement signals to be read by each of the sensors' individual measurement electronic circuits located within the common electronics module. These measurement signals are then processed in the common electronics module.

The common electronics module has intelligent processing. The common electronics module may be positioned anywhere on the integrity monitoring spool, but to allow easier routing of the high-pressure metal tubing, it is preferably located closer to the center of the integrity monitoring spool. The common electronics module further comprises a top of line corrosion measurement electronics circuit, a bottom of line corrosion sensor measurement electronics circuit, a comparator corrosion measurement electronics circuit, an erosion measurement electronics circuit, a pressure and temperature measurement electronics circuit, an acoustic sand detector measurement electronics circuit, an active master processor, and an active network interface electronics. In another corrosion sensor only configuration, the common electronics module further comprises: a top of line corrosion measurement electronics circuit, a bottom of line corrosion sensor measurement electronics circuit, a comparator corrosion measurement electronics circuit, a second top of line corrosion measurement electronics circuit, a second bottom of line corrosion sensor measurement electronics circuit, a second comparator corrosion measurement electronics circuit an active master processor, and an active network interface electronics.

Each individual measurement electronics circuit further comprises individual processors. These individual processors regulate the sensor excitation and process measurement signals from the individual sensor heads, which are passed through the individual sensor signal wires and the individual feedthroughs on the common electronics module. This individually processed sensor data is then communicated using an internal digital protocol to the active master processor which performs additional real-time data processing operations on the sensor data to improve data quality and accuracy by comparing, cross-checking, combining and processing data from the various different sensors. A second inactive master processor may be implemented for redundancy purposes in case the active master processor stops working. This additionally processed sensor data is then communicated to the active network interface electronics for onward transmission to the external control module. A second network interface electronics may be included for redundancy and backup purposes if the active network interface electronics fails.

Alternatively, the body of the integrity monitoring spool apparatus may further comprise a Venturi profile. The Venturi profile comprises a convergent body section, a throat, a divergent body section, and an erosion sensor. The convergent body section has an internal diameter that is reducing and is upstream of the throat. The divergent body section is located downstream of the throat and has an internal diameter that is increasing. The erosion sensor would be disposed of at or close to the throat of the Venturi profile to maximize the erosion rate on the erosion sensor head for any given process condition, thus providing an early warning if erosion rates start to increase. The Venturi will help to improve the consistency of sensor performance as process conditions change over time, because the convergent section of the Venturi has the effect of increasing sand particle velocity, the sand particle flux intensity and uniformity across the flowing area, and because the erosion sensor head will now occupy a larger portion of the cross-section. The proportions of the Venturi profile would provide a sufficiently long convergent section to allow particles time to accelerate, and a sufficiently long divergent section to prevent excessive flow separation and losses. A second erosion sensor could be introduced up or downstream of the Venturi profile for comparison. A qualitative assessment of particle size, or changes in particle sizes may be carried-out by evaluating the difference in erosion rates measured by the two sensors. Large particles are less easily entrained, less readily accelerated in the Venturi, and more likely to strike the convergent wall. Small particles will be more easily entrained by the fluid and therefore will accelerate and reach the Venturi throat without losing energy through wall collisions. The result is that the erosion sensor disposed of at or close to the throat of the Venturi profile will show a much higher erosion rate for smaller particles compared to the second erosion sensor, with the difference reducing for larger particles.

In addition, the same qualitative assessment of particle size can be carried-out by comparing the erosion sensor readings with those of the passive acoustic measurement device if the Venturi profile is present. Larger particles are more likely to strike the convergent wall of the Venturi profile and generate acoustic signals, and less likely to cause erosion on the erosion sensor head. Smaller particles are more easily entrained in the convergent body section of the Venturi profile, and therefore are more likely to accelerate and reach the erosion sensor at the Venturi throat generating erosion, but not acoustic signals.

In a first embodiment, the present invention provides a subsea integrity monitoring spool apparatus for effective monitoring, cross-checking, and measuring data of flow-lines or pipelines from a plurality of different sensors to process data in real-time. The subsea integrity monitoring spool apparatus of the first embodiment having: a body portion comprising first and second body portion ends, a longitudinal section for carrying process fluids and extending between said ends, and a plurality of process-rated penetrations for mounting intrusive sensors; a first corrosion sensor mounted on the body portion at a first process-rated penetration and adapted to generate measurement signals indicative of corrosion of the body portion, the first corrosion sensor comprising: an sample element not protected from corrosion and in fluid communication with process fluids carried through the body, the sample element adapted to measure corrosion; and a reference element protected from corrosion, the reference element utilized as a reference of corrosion measurement to the sample element; and a comparator corrosion sensor mounted on the body portion at a second nearby process-rated penetration and adapted to generate measurement signals resulting from process-related effects, the comparator corrosion sensor comprising a sample element and a reference element, the reference element and sample element being fully protected from corrosion.

The first embodiment may be further characterized in one or more of the following manners: wherein the process-rated penetrations for mounting intrusive sensors are configured to support a top of line corrosion sensor, a bottom of line corrosion sensor, a comparator corrosion sensor, a pressure and temperature sensor, and an erosion sensor; further comprising a passive non-intrusive acoustic sand detector mounted on the body portion and configured to measure acoustic signals generated by particles flowing in the process fluids and for particle sizing by comparison with an erosion sensor probe output; wherein the sample element and the reference element of the comparator corrosion sensor are housed in a same head as the sample element and reference element of the first corrosion sensor; wherein a sample element and a reference element of a comparator erosion sensor are housed in a same head as the sample element and reference element of a first erosion sensor; wherein each of the intrusive sensors are configured with a single or a dual barrier to process pressure, the single or dual barrier comprising a penetrator to permit electrical signals to pass through; wherein the body portion comprises a Venturi profile adapted to improve consistency of sensor performance as process conditions change over time, the Venturi profile comprising: a throat comprising a first erosion sensor, the throat adapted to maximize erosion rate on the first erosion sensor; a convergent body section with a decreasing diameter adapted to increase particle velocity inside the process fluids, the convergent body section disposed upstream of the throat; and a divergent body section with an increasing diameter adapted to decrease particle velocity inside the process fluids, the divergent body section disposed downstream of the throat; further comprising a second erosion sensor whereby first and second erosion rates associated respectively with the first and second erosion sensors are compared to qualitatively assess deduced particle size or changes in particle size, the second erosion sensor not located within the throat and being active with its sample element exposed to erosion; and/or further comprising a common electronics module having intelligent processing to process at least the measurement signals indicative of corrosion of the body portion generated by the first corrosion sensor and the measurement signals resulting from process-related effects generated by the comparator corrosion sensor and adapted to transmit the processed measurement signals representing corrosion of the body portion and compensated for process-related effects to an external control module.

In a second embodiment, the present invention provides a subsea integrity monitoring spool apparatus for effective monitoring, cross-checking, and measuring data of flow-lines or pipelines from a plurality of different sensors to process data in real-time. The subsea integrity monitoring spool apparatus of the second embodiment having: a body portion comprising first and second body portion ends, a longitudinal section for carrying process fluids and extending between said ends, and a plurality of process-rated penetrations for mounting intrusive sensors; a common electronics module having intelligent processing, the common electronics module comprising: a housing mounted on the body portion adapted to carry process fluids and comprising a plurality of process-rated penetrations for mounting intrusive sensors; an active master processor disposed within the housing and comprising an input adapted to receive a plurality of signals derived from a plurality of measurement signals generated respectively by a plurality of sensors mounted at respective penetrations of the plurality of process-rated penetrations, the active master processor adapted to perform, based at least in part on the plurality of received signals, one or more of the following set of operations: comparing data; cross-checking data; combining data; and automatically calculating revised sensor coefficients, the active master processor adapted to output a set of signals related to monitored conditions at the subsea equipment monitoring apparatus; wherein the plurality of measurement signals includes: a signal from an active corrosion sensor; at least one signal generated by a sample element not protected from corrosion and in fluid communication with process fluids carried through the body portion, the sample element adapted to measure corrosion; and at least one signal generated by a reference element protected from corrosion and being adapted to measure corrosion.

The second embodiment may be further characterized in one or more of the following manners: wherein the housing further comprises feedthroughs for the plurality of measurement signals generated respectively by the plurality of sensors mounted at respective penetrations of the plurality of process-rated penetrations, the feedthroughs adapted to communicate the plurality of measurement signals to a plurality of independent sensor-specific measurement electronics circuits, each of the plurality of independent sensor-specific measurement electronics circuits comprising an independent sensor-specific processor adapted to process received measurement signals; wherein the active master processor is adapted to receive signals derived from a top of line corrosion sensor, a bottom of line corrosion sensor; a comparator corrosion sensor; a pressure and temperature sensor; and an erosion sensor; the comparator corrosion sensor comprising a sample element and a reference element, the reference and sample elements being fully protected from corrosion and adapted to generate measurement signals representing process-related effects of the process fluids, the top of line corrosion sensor and bottom of line corrosion sensor adapted to measure corrosion and comprising an sample element not protected from corrosion and in fluid communication with process fluids carried through the body portion, the sample element adapted to measure corrosion and a reference element protected from corrosion, the reference element utilized as a reference of measurement to the sample element; wherein the active master processor is adapted to receive signals derived from a passive non-intrusive acoustic sand detector configured to measure acoustic signals generated by particles flowing in the process fluids, the acoustic signals communicated through a feedthrough, on the housing, to an independent sensor-specific measurement electronics circuits comprising an independent sensor-specific processor adapted to process the acoustic signals generated by the acoustic sand detector; wherein the active master processor is adapted to receive signals derived from a first erosion sensor disposed within a throat of a Venturi profile to provide an early warning when erosion rates start to increase; further comprising a second erosion sensor whereby first and second erosion rates associated respectively with the first and second erosion sensors are compared to qualitatively assess deduced particle size or changes in particle size, the second erosion sensor not located within the throat and being active with its sample element exposed to erosion; and/or wherein the set of signals related to monitored conditions at the subsea equipment monitoring apparatus are communicated to an active network interface adapted to communicate the set of signals related to monitored conditions at the subsea equipment monitoring apparatus onward to a subsea external control module.

In yet a third embodiment the present invention provides a method for enhanced compensation of Electrical Resistance type sensors in a subsea environment, the method comprising: fully protecting a sample element and a reference element of a comparator sensor so the sample element and the reference element are not susceptible to corrosion or erosion; exposing the sample element and the reference element of the comparator sensor to process-related effects in the process environment; measuring the process-related effects on the sample element and the reference element of the comparator sensor to generate a comparator sensor measurement signal resulting from the process-related effects; comparing the comparator sensor measurement signal to an active sensor measurement signal and accounting for the effect of the process-related effects on the sample element and the reference element of the comparator sensor in the active sensor measurement signal, the active sensor measurement signal derived from the effect of a electrochemical or mechanical action on a sample element and a reference element of the active sensor, the sample element of the active sensor configured to be susceptible to process conditions and the reference element of the active sensor configured to be protected from process conditions; and generating a better compensated reading by analyzing the comparator sensor measurement signal and the active sensor measurement signal to determine whether the effects on the active sensor is a process event or a genuine effect of metal loss.

The third embodiment may be further as wherein the active sensor is an erosion sensor or a corrosion sensor and the comparator sensor is a comparator corrosion sensor or a comparator erosion sensor.

### Brief Description of the Drawings

In order to facilitate a complete understanding of the present invention, this system, and the terms used, reference is now made to the accompanying drawings, in which like elements are referenced with like numerals. These drawings should not be construed as limiting the present invention or system, but are exemplary and for reference.
**Figure 1** provides a front perspective view of the first exemplary embodiment of an integrity monitoring spool apparatus ("IMSA") 100 according to the present invention;
**Figure 2** provides a back-perspective view of the first exemplary embodiment of an IMSA 100 according to the present invention;
**Figure 3** provides a lateral cross-section view of the first exemplary embodiment of the IMSA 100 including a Venturi profile configuration and perspective of the second embodiment common electronics module 300 according to the present invention;
**Figure 4** provides a circuit diagram demonstrating the inner workings of the second embodiment common electronics module 300 according to first exemplary embodiment of the present invention;
**Figure 5** provides a front perspective view of the corrosion sensor configuration of the IMSA 100 of the present invention;
**Figure 6** provides a cross-section view of a corrosion sensor configuration of the IMSA 100 of the present invention; and
**Figure 7** provides a provides a circuit diagram demonstrating the inner workings of the second embodiment common electronics module 300 according to the corrosion sensor embodiment of the IMSA 100 of the present invention.

### Detailed Description

The present invention and system will now be described in more detail with reference to exemplary embodiments as shown in the accompanying drawings. While the present invention and system is described herein with reference to the exemplary embodiments, it should be understood that the present invention and system is not limited to such exemplary embodiments. Those possessing ordinary skill in the art and having access to the teachings herein will recognize additional implementations, modifications, and embodiments as well as other applications for use of the invention and system, which are fully contemplated herein as within the scope of the present invention and system as disclosed and claimed herein, and with respect to which the present invention and system could be of significant utility.

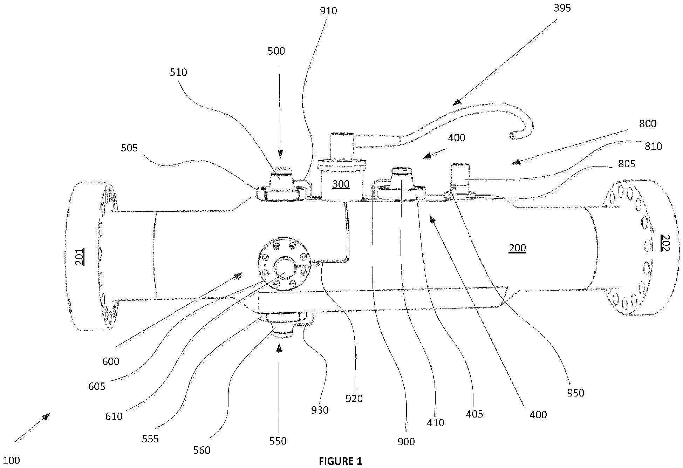

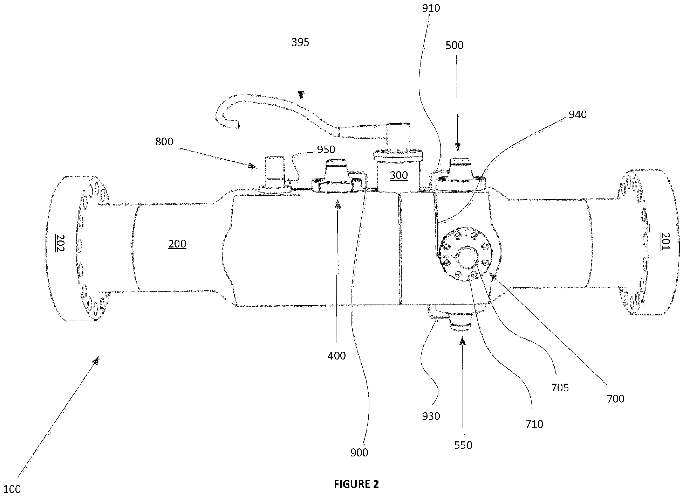

With reference first to Figure 1, a front perspective view of the first exemplary embodiment of the integrity monitoring spool apparatus ("IMSA") 100 is provided. The IMSA comprises a body 200, a common electronics module 300, an erosion sensor assembly 400 located downstream of all other intrusive sensors to prevent flow disturbance at the locations of the other sensors, a top of line corrosion sensor assembly 500 located at the regions of highest corrosion risk, a bottom of line corrosion sensor assembly 550 located at the regions of highest corrosion risk, a comparator corrosion sensor assembly 600 located nearby the corrosion sensors, for example at 3 o'clock, a pressure and temperature sensor assembly 700 (shown in Figure 2) located directly opposite the comparator corrosion sensor 600 on the body 200 to monitor for signs of drift and to provide an independent reference for checking and updating the calibration of other devices on the body (shown in Figure 2), an acoustic sand detector assembly 800, and individual high-pressure metal tubing 900, 910, 920, 930, and 940 (shown in Figure 2) and 950.

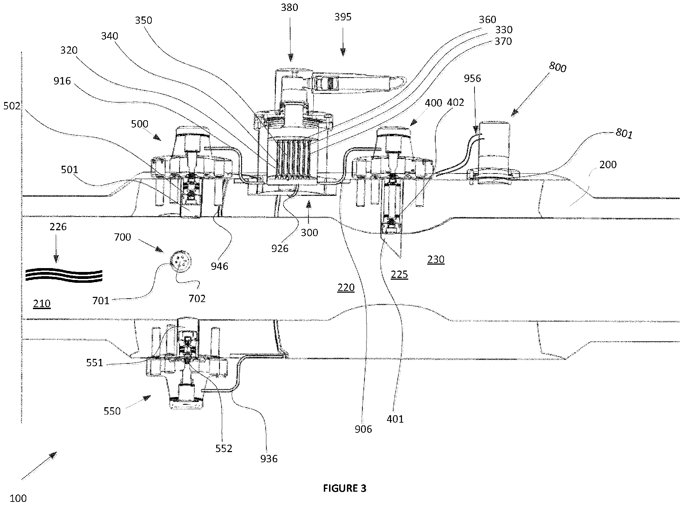

The body 200, either a forging, which is shown in Figure 1, or a free-issue section of pipe, contains a bore 210 containing process fluids 226 (shown in Figure 3). Said forging is instrumented by the sensor vendor and is anticipated to be installed on a subsea Christmas Tree, a manifold or any other type of in-field spool assembly, or pipeline. Said free-issue section of pipe may be free-issued or sourced by the sensor vendor to the project's specifications. This instrumented free-issue section of pipe is either welded or flanged into a spool or pipeline. The body is enclosed on a first end with a first end flange 201 and a second end with a second end flange 202 allowing easy connection. The body further comprises numerous process rated penetrations located throughout the body to support multiple intrusive sensors. The number of penetrations located on the IMSA 100 will depend on the number of intrusive sensors specified. For example, Figure 1 comprises an erosion sensor 400, a top of line corrosion sensor 500, a bottom of line corrosion sensor 550, a comparator corrosion sensor 600, and a pressure and temperature sensor 700. Thus, there are five process rated penetrations located throughout the body 200 of the IMSA 100.

The first process rated penetration supports the erosion sensor 400. The erosion sensor 400 is located downstream of all other intrusive sensors to prevent flow disturbance at other sensor locations. The erosion sensor 400 further comprises a sensor head 401 (shown in Figure 3), sensor neck 402 (shown in Figure 3), sensor flange 405 and sensor housing 410 and is an Electrical Resistance type sensor. The sensor head 401 further comprises the sensor transducer that provides measurement signals for the erosion sensor 400 which can then be read. The sensor neck 402 connects the sensor head 401 to the sensor flange 405 and the sensor housing 410. The sensor flange 405 provides the sealing interface of the top of the line erosion sensor 400 to the body 200 and is a structural component necessary for resisting pressure. The sensor housing 410 provides an atmospheric cavity for feeding the erosion sensor signal wires 906 (shown in Figure 3) into the high-pressure metal tubing 900. The erosion sensor, further comprises a sample element and a reference element, which is protected and is not subject to erosion. As the sample element erodes, the resistance of the sample element of the erosion sensor 400 increases and this resistance is compared against the reference element to determine erosion rate. The erosion sensor measurement electronics processor may use temperature compensation algorithms which are tuned to account for minute differences in sample and reference element properties, which influence metal loss readings when the temperature changes. A comparator erosion sensor could be included on the IMSA 100 (as described in paragraph 0025), for example wherein the sample element is mounted flush or sub-flush such that it does not experience any erosion, but is not shown in Figure 1 because corrosion sensors are often more likely to benefit from the improved performance resulting from the comparator sensor compensation, due to the larger temperature coefficient of resistance seen in Carbon Steel compared to corrosion resistant alloys such as Inconel 625. The erosion sensor 400 is well known to individuals of ordinary skill in the art.

The second process rated penetration supports the top of line corrosion sensor 500. The top of line corrosion sensor 500 is located near the top of the line of the body 200. The top of line corrosion sensor 500 further comprises a sensor head 501 (shown in Figure 3), sensor neck 502 (shown in Figure 3), sensor flange 505 and sensor housing 510 and is an Electrical Resistance type sensor. The sensor head 501 further comprises the sensor transducer that provides measurement signals for the top of line corrosion sensor 500 which can then be read. The sensor neck 502 connects the sensor head 501 to the sensor flange 505 and the sensor housing 510. The sensor flange 505 provides the sealing interface of the top of the line corrosion sensor 500 to the body 200 and is a structural component necessary for resisting pressure. The sensor housing 510 provides an atmospheric cavity for feeding the top of line corrosion sensor signal wires 916 (shown in Figure 3) into the high-pressure metal tubing 910. The top of line corrosion sensor further comprises a sample element and a reference element which is protected and not subject to corrosion. As the sample element corrodes, the resistance of the sample element of the top of line corrosion sensor 500 increases and this resistance is compared against the reference element to determine corrosion rate of the body 200 and ultimately of the IMSA 100. The top of line corrosion sensor measurement electronics processor 500 may use temperature compensation algorithms which are tuned to account for minute differences in active and reference element properties, which influence metal loss readings when the temperature changes. The top of the line corrosion sensor 500 is well known to individuals of ordinary skill in the art.

The third process rated penetration supports the bottom of line corrosion sensor 550. The bottom of line corrosion sensor 550 is located near the bottom of the line of the body 200. The bottom of line corrosion sensor 550 further comprises a sensor head 551 (shown in Figure 3), sensor neck 552 (shown in Figure 3), sensor flange 555 and sensor housing 560 and is an Electrical Resistance type sensor. The sensor head 551 further comprises the sensor transducer that provides measurement signals for the bottom of line corrosion sensor 550 from which data can then be read. The sensor neck 552 connects the sensor head 551 to the sensor flange 555 and the sensor housing 560. The sensor flange 555 provides the sealing interface of the bottom of the line corrosion sensor 550 to the body 200 and is a structural component necessary for resisting pressure. The sensor housing 560 provides an atmospheric cavity for feeding the bottom of line corrosion sensor signal wires 936 (shown in Figure 3) into the high-pressure metal tubing 930. The bottom of line corrosion sensor further comprises a sample element and a reference element which is protected and not subject to corrosion. As the sample element corrodes, the resistance of the sample element of the bottom of line corrosion sensor 550 increases and this resistance is compared against the reference element to determine corrosion rate of the body 200 and ultimately of the IMSA 100. The bottom of line corrosion sensor 550 may use temperature compensation algorithms which are tuned to account for minute differences in sample and reference element properties, which influence metal loss readings when the temperature changes. The bottom of the line corrosion sensor 550 is well known to individuals of ordinary skill in the art.

The fourth process rated penetration supports the comparator corrosion sensor 600. The comparator corrosion sensor 600 is located nearby the top of line corrosion sensor 500 and the bottom of line corrosion sensor 550, potentially at 3 o'clock. The comparator corrosion sensor 600 further comprises a sensor head 601 (not visible in any Figure, but identical in configuration as the top of line corrosion sensor 500 except that a sample element which is fully protected from corrosion is present, rather than an unprotected sample element), sensor neck 602 (not visible in any Figure, but identical in configuration as the top of line corrosion sensor 500), sensor flange 605 and sensor housing 610. The sensor head 601 further comprises the sensor transducer that provides measurement signals for the comparator corrosion sensor 600 from which data can then be read. The sensor neck 602 connects the sensor head 601 to the sensor flange 605 and the sensor housing 610. The sensor flange 605 provides the sealing interface of the comparator corrosion sensor 600 to the body 200 and is a structural component necessary for resisting pressure. The sensor housing 610 provides an atmospheric cavity for feeding the comparator corrosion sensor signal wires 926 (shown in Figure 3) into the high-pressure metal tubing 920. The comparator corrosion sensor is beneficial because in practice with a hot flowing process, a small temperature gradient is present through the sample and reference elements found in both the top of line 500 and bottom of line 550 corrosion sensors. The configuration of the comparator corrosion sensor 600 is not known in the art. The comparator corrosion sensor 600 further comprises a sample and a reference element, both of which are fully protected from corrosion, for example by using a coating to prevent corrosion. Hence, the reference and sample elements in the comparator corrosion sensor 600 experience the same temperature gradient as the active sensors, so the effect of the temperature gradient which distorts the sensor measurement, can be compensated for using the comparator sensor readings. This will aid in determining if a change in the output of the top of line 500 and bottom of line 550 corrosion sensors is a real effect or just the consequence of a process event. The respective locations of the sample and reference elements of the comparator corrosion sensor 600 will be identical for the reference and sample elements of the active corrosion sensors to accurately replicate the temperature distribution in the active corrosion sensor elements. Moreover, the location of the comparator sensors relative to active sensors is significant because ideally, the comparator sensor should be subject to the same process and temperature conditions as the active sensors, so the comparator sensor needs to be situated as close to the active sensors as possible. Preferably, the comparative sensor would be situated as the same 'O Clock' position on the body 200 as the active sensor it is intended to correct. For another configuration, each active sensor could have a dedicated congruent comparator sensor and each comparator sensor could be at the same 'O Clock' position as its respective active sensor.

The acoustic sand detector 800 is located downstream the erosion sensor 400 and is mounted on and acoustically coupled to the body 200. The acoustic sand detector 800 is non-intrusive and thus does not require a process rated penetration. The acoustic sand detector comprises a detector head 801 (shown in Figure 3), a detector flange 805 and a detector housing 810. The detector flange 805 is used to attach the acoustic sand detector 800 to the body 200 and provide the clamping force necessary to ensure good acoustic coupling to the pipe. The detector housing 810 provides an atmospheric cavity for feeding the acoustic sand detector signal wires 956 into the high-pressure metal tubing 950. The acoustic sand detector 800, primarily provides an independent measurement of sand to support and verify the output of the erosion sensor 400. Additionally, although not essential the acoustic sand detector 800 detects acoustic signals generated in the convergent section of the Venturi within the internal body 200 of the IMSA 100 and can help determine relative particle sizing. Larger particles are more likely to strike the internal wall of the body 200 and generate acoustic signals, while smaller particles are less likely to strike the internal wall of the body 200 and generate acoustic signals, if at all. Moreover, the acoustic sand detector 800 operates when the Venturi profile is absent by measuring acoustic signals generated from sand impingements on nearby bends up or downstream of the IMSA 100.

As shown in Figures 1 and 2, the high-pressure metal tubing 900, 910, 920 (Figure 1 only), 930, 940 (Figure 2 only), and 950 from each device runs along the body 200 of the IMSA 100 via machined grooves in the body 200 and are connected on a second end via individual feedthroughs on the common electronics module 300. The common electronics module 300 is mounted close to the center of the body 200 to allow for easier routing of the high-pressure metal tubing 900, 910, 920, 930, 940, and 950. The signal wires 906, 916, 926, 936, 946, and 956 (all shown in Figure 3) for each device located on the body 200 carry measurement signals from each independent sensor's transducer located in the sensor head 401, 501, 551, 601, 701, and 801 (all but 601 shown in Figure 3). The measurement signals and excitation are then carried between each sensor's individual measurement electronics circuits and the individual sensor heads. These measurement signals are then further processed in the common electronics module 300.

With reference to Figure 2, back-perspective view of the first exemplary embodiment of the IMSA 100 is provided. Any element of the IMSA 100 that is not mentioned is purposeful, as they are identical to the elements in Figure 1. Figure 2 illustrates the pressure and temperature sensor 700 which could not be viewed in Figure 1. The fifth process rated penetration supports the pressure and temperature sensor 700. The pressure and temperature sensor 700 is located near the corrosion and erosion sensors. The pressure and temperature sensor 700 further comprises a sensor head 701 (shown in Figure 3), sensor neck 702 (shown in Figure 3), sensor flange 705 and sensor housing 710. The sensor head 701 further comprises the sensor transducer that provides measurement signals for the pressure and temperature sensor 700 from which data can then be read. The sensor neck 702 connects the sensor head 701 to the sensor flange 705 and the sensor housing 710. The sensor flange 705 provides the sealing interface of the pressure and temperature sensor 700 to the body 200 and is a structural component necessary for resisting pressure. The sensor housing 710 provides an atmospheric cavity for feeding the pressure and temperature sensor signal wires 946 (shown in Figure 3) into the high-pressure metal tubing 940. A typical pressure and temperature sensor transducer will use a piezoresistive element for pressure measurement and a platinum resistance thermometer for temperature measurement.

The pressure and temperature sensor 700 has the following listed functions. Firstly, the pressure and temperature sensor readings can be used to verify the integrity of the corrosion sensor readings and erosion sensor readings from the sensors present on the body 200 of the IMSA 100. In addition to metal loss measurement, active corrosion sensors 500, 550, comparator corrosion sensor 600 and erosion sensor 400 provide a temperature reading which is based on the resistance of their individual sensor reference elements. Each individual sensor's reference element resistance measurement is intrinsically linked to the metal loss measurement because it forms part of the same electronics measurement circuit. If the metal loss measurement is compromised as a result of damage to the electronics measurement circuit or reference element protection, then the difference in temperature readings between each active and comparator corrosion sensors 500, 550, 600 or erosion sensor 400 and the pressure-temperature sensor 700 will change with time. By monitoring these differences to ensure that they are stable, the user can verify the integrity of the corrosion sensor readings and erosion sensor readings. Alternatively, if some time-dependent 'drift' is observed, then further investigation can be carried-out to diagnose the fault. Secondly, the pressure and temperature sensor readings can be used to adjust the calibration of the corrosion and erosion sensor readings. Corrosion and erosion sensors are factory calibrated to optimise the temperature compensation. As the sample elements, present in the active corrosion sensors 500, 550 and erosion sensor 400 corrode or erode, the temperature compensation performance may become sub-optimal. In such cases, it is useful to be able to adjust coefficients after deployment. In order to be able to make such changes, it is helpful to have an accurate independent temperature measurement. The pressure and temperature sensor 700 provides this independent source of temperature measurement. Temperature readings from the pressure and temperature sensor 700 can be combined with metal loss readings for the active corrosion 500, 550 or erosion sensors 400 to calculate revised coefficients. Moreover, metal loss and reference temperature data from the corrosion and erosion sensors will be stored to non-volatile memory by the master processor 380, as well as temperature data from the pressure and temperature sensor 700. The calibration coefficients may be recalculated once data has been logged at two or more difference temperatures for a sufficient period of time, usually less than an hour (assuming no significant corrosion is detected during that period). These revised coefficients could be automatically calculated by the active master processor 380 and proposed to the operator as required, typically every few months or even years depending on corrosion or erosion rates. Furthermore, the pressure and temperatures sensor measurements are useful independently as data that can be reported topsides, regardless of whether this data is being used to correct or enhance the measurements of other devices on the body 200 of the IMSA 100.

In an alternate configuration, the pressure and temperature sensor 700 may be included in the same sensor head as the top of line 500 bottom of line 550, and comparator corrosion sensors 600 and/or in the erosion sensor 400 head. This would reduce the number of process rated penetrations on the body 200. Examples of the corrosion sensors 500, 550 co-located in the same sensor as the pressure and temperature sensor 700 are sold at http://www.teledynemarine.com/corrosion-sensor?ProductLineID=29 and the configuration with the pressure and temperature sensor 700 co-located in the same sensor as the erosion sensor 400 are sold at http://www.teledynemarine.com/erosion-sensor?ProductLineID=29.

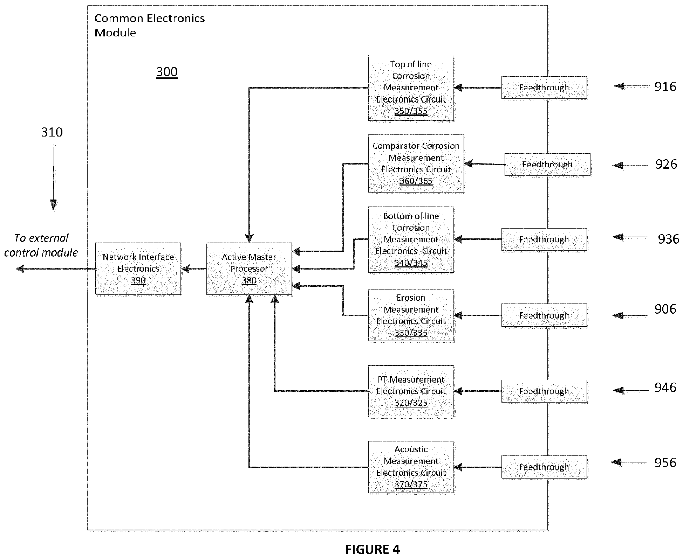

With reference to Figure 3, a lateral cross-section view of the first exemplary embodiment including a Venturi profile configuration and a perspective of the second embodiment common electronics module 300 of the IMSA 100 is provided. The common electronics module 300 has intelligent processing capabilities and further comprises a pressure and temperature measurement electronics circuit 320 which further comprises a pressure and temperature sensor processor 325 (shown in Figure 4), an erosion measurement electronics circuit 330 which further comprises an erosion sensor processor 335 (shown in Figure 4), a bottom of line corrosion measurement electronics circuit 340 which further comprises a bottom of line corrosion sensor processor 345 (shown in Figure 4), a top of line corrosion measurement electronics circuit 350 which further comprises a top of line corrosion sensor processor 355 (shown in Figure 4), a comparator corrosion measurement electronics circuit 360 which further comprises a comparator corrosion sensor processor 365 (shown in Figure 4), an acoustic sand detector measurement electronics circuit 370 which further comprises an acoustic sand detector processor 375 (shown in Figure 4), an active master processor 380 and a network interface electronics 390 (shown in Figure 4). Redundant measurement circuits could be included for each device if required for improved system reliability.

The transducers located within the sensor heads of each device on the IMSA 100 provide measurement signals when energized which can then be read. Each independent device's measurement signals are then read via each device's individual signal wires to each device's individual electronics measurement circuits, where the signals are processed and converted to digital outputs via the individual device processors within the individual electronics measurement circuits. This initially processed data is then communicated via the internal digital protocol to the active master processor 380. The active master processor 380 then performs additional real-time processing operations on the sensor data to improve data quality and accuracy by comparing, combining, and processing data from all the different sensors in one place. This additionally processed data is then communicated to the network interface electronics 390 for onward transmission to the external control module 310. In an alternative configuration, there is an inactive master processor and an inactive network interface electronics. If either the active master processor 380 or network interface electronics 390 fail, processing and communications can be carried out by the redundant circuits. Furthermore, power and communications will be supplied to the common electronics module 400 from the external control module 310 (shown in Figure 4) via jumpers 395 which may be potentially dual redundant.

In an alternative configuration, the individual measurement electronics circuits for each sensor are housed at the sensor location to reduce errors due to signal attenuation or distortion, and the common electronics module 300 would then only contain the active master processor 380 and the network interface electronics 390. Furthermore, if the top of line corrosion sensor 500 and comparator corrosion sensor 600 and/or the bottom of line corrosion sensor 550 and comparator corrosion sensor 600 are co-located in the same sensor head and the measurement electronics circuits are housed at the sensor location, it may be practical to implement a dual channel measurement such that readings for active and comparator sensors are processed in the same processor. Each dual measurement circuit would take measurements for a top or bottom of line corrosion sensor and a comparator sensor which are both located in the same sensor head. Preferably, the comparator sensor head is mounted flush or slightly sub-flush to the pipe inner diameter (similar to corrosion sensors) in a location where there is minimal wall erosion.

In another configuration, a Venturi profile may be included within the body 200 of the IMSA 100. The Venturi profile consists of a convergent body section 220, a throat 225, a divergent body section 230, and an erosion sensor 400. The convergent body section 220 has an internal diameter that is reducing and is upstream of the throat 225. The divergent body section 230 is located downstream of the throat 225 has an internal diameter is increasing. The erosion sensor 400 would be disposed of at or close to the throat 225 of the Venturi profile to maximize the erosion rate on the erosion sensor head 401 for any given process condition, thus providing an early warning if erosion rates start to increase. The Venturi profile will help to improve the consistency of the sensor performance as process conditions change over time, because the convergent body section 220 of the Venturi profile has the effect of increasing sand particle velocity and particle flux intensity and uniformity across the flowing area, and because the erosion sensor head 401 will now occupy a larger portion of the cross-section. The proportions of the Venturi profile would provide a sufficiently long convergent body section 220 to allow particles time to accelerate, and a sufficiently long divergent body section 230 to prevent excessive flow separation and losses. A second erosion sensor could be introduced upstream or downstream of the Venturi profile for comparison. A qualitative assessment of particle size, or changes in particle sizes may be carried-out by evaluating the difference in erosion rates measured by the two sensors. Large particles are less easily entrained, less readily accelerated in the Venturi profile, and more likely to strike the convergent wall. Small particles will be more easily entrained by the fluid and therefore will accelerate and reach the Venturi throat 225 without losing energy through wall collisions. The result is that the erosion sensor 400 will show a much higher erosion rate than the second erosion sensor for smaller particles, with the difference reducing for larger particles.

In addition, the same qualitative assessment of particle size can be carried-out by comparing the erosion sensor 400 readings with those of the acoustic sand detector 800 readings, if the Venturi profile is present. Larger particles are more likely to strike the convergent wall of the Venturi profile and generate acoustic signals, and less likely to cause erosion on the erosion sensor head 401. Smaller particles are more easily entrained in the convergent body section 220 of the Venturi profile, and therefore are more likely to accelerate and reach the erosion sensor 400 at the Venturi throat 225 generating erosion, but not acoustic signals. Moreover, the acoustic sand detector 800 operates if the Venturi profile is absent by measuring acoustic signals generated from sand impingements on nearby bends up or downstream of the IMSA 100.

All measurement signals from the erosion sensor 400, (and potentially from the comparator erosion sensor, if included) are then read from the common electronics module 300, via the signal wires 906, for measurement signal processing by the erosion sensor processor 335 located in the erosion measurement electronics circuit 330. Process conditions such as pressure, temperature, water content, velocity and flow regime will change over the life of the IMSA 100. Consequently, the regions of maximum sand flux and erosion potential also change, thus the position of the erosion sensor 400 may be optimal when first installed, but sub-optimal after a few years of service. By locating the erosion sensor at the Venturi throat, the problem of sub-optimal performance over time is reduced or even eliminated. Advantageously, the use of the Venturi profile would improve the consistency of the erosion sensor 400 performance as process conditions change over time.

Further Figure 3 illustrates the erosion sensor 400 further comprising a sensor head 401, sensor neck 402, the top of line corrosion sensor 500 further comprising a sensor head 501, sensor neck 502, the bottom of line corrosion sensor 550 further comprising a sensor head 551, sensor neck 552, and the acoustic sand detector 800 further comprising a sensor head 801. The pressure and temperature sensor 700 (only inside viewable due to cross-section view) and comparator corrosion sensor 600 are not visible in this cross section, but are similar in overall structure to the top of line corrosion sensor 500 and bottom of line corrosion sensor 600 except that the pressure and temperature sensor 700 uses a different type of sensor head. Further, erosion sensor signal wires 906, top of line corrosion sensor signal wires 916, comparator corrosion sensor signals wires 926, bottom of line corrosion sensor signal wires 936, pressure and temperature sensor signal wires 946 and acoustic sand detector wires 956 pass excitation and measurement signals to the common electronics module 300 for processing.

With reference now to Figure 4, a circuit diagram demonstrating the inner workings of the second embodiment common electronics module 300 according to the first exemplary embodiment IMSA 100 of the present invention is provided. This diagram illustrates each device's individual feedthrough into the common electronics module 300 via each individual device's signal wires. The top of line corrosion sensor signal wires 916 carry measurement signals from the top of line corrosion sensor head 501 (shown in Figure 3), which are passed through the sensor neck 502 (shown in Figure 3), and sensor housing 510. The top of line corrosion sensor signal wires 916 then connect on a second end to the common electronics module 300 via a feedthrough. The signals are further passed to the top of line corrosion measurement electronics circuit 350 which further comprises the top of line corrosion sensor processor 355 that processes the signals. The comparator corrosion sensor signal wires 926 carry measurement signals from the comparator corrosion sensor head 601, which are passed through the sensor neck 602, and sensor housing 610. The comparator corrosion signal wires 926 then connect on a second end to the common electronics module 300 via a feedthrough. The signals are further passed to the comparator corrosion measurement electronics circuit 360 which further comprises the comparator corrosion sensor processor 365 that processes the signals. The bottom of line corrosion sensor signal wires 936 carry measurement signals from the bottom of line corrosion sensor head 551 (shown in Figure 3), which are passed through the sensor neck 552 (shown in Figure 3), and sensor housing 560. The bottom of line corrosion sensor signal wires 936 then connect on a second end to the common electronics module 300 via a feedthrough. The signals are then further passed to the bottom of line corrosion measurement electronics circuit 340 which further comprises the bottom of line corrosion sensor processor 345 that processes the signals. The erosion sensor signal wires 906 carry measurement signals from the erosion sensor head 401 (shown in Figure 3), which are passed through the sensor neck 402 (shown in Figure 3), and sensor housing 410. The erosion sensor signal wires 906 then connect on a second end to the common electronics module 300 via a feedthrough. The signals are then further passed to the erosion measurement electronics circuit 330 which further comprises erosion sensor processor 335 that processes the signals. The pressure and temperature sensor signal wires 946 carry measurement signals from the pressure and temperature sensor head 701 (shown in Figure 3), which are passed through the sensor neck 702 (shown in Figure 3), and sensor housing 710. The pressure and temperature sensor signal wires 946 then connect on a second end to the common electronics module 300 via a feedthrough. The signals are then further passed to the pressure and temperature measurement electronics circuit 320 which further comprises the pressure and temperature sensor processor 325 that processes the signals. The acoustic sand detector signal wires 956 carry measurement signals in the acoustic sand detector head 801 (shown in Figure 3), which are passed through the detector housing 810. The acoustic sand detector signal wires 956 then connect on a second end to the common electronics module 300 via a feedthrough. The signals are then further passed to the acoustic sand detector measurement electronics circuit 370 which further comprises the acoustic sand detector processor 375 that processes the signals.

All the further processed data from each device on the IMSA 100 is then communicated via an internal digital protocol to the active master processor 380 which performs additional real-time data processing operations on the sensor data to improve data quality and accuracy by comparing, cross-checking, combining and processing data from the various different sensors. A second inactive master processor may be implemented for redundancy purposes in case the active master processor fails or has complications. This additionally processed sensor data is then communicated to the active network interface electronics 390 for onward transmission to the external control module 310. A second network interface electronics may be included for redundancy and backup purposes if the active network interface electronics fails.

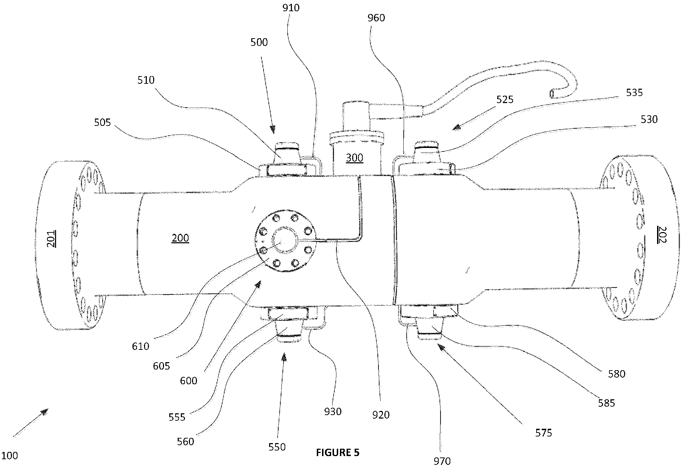

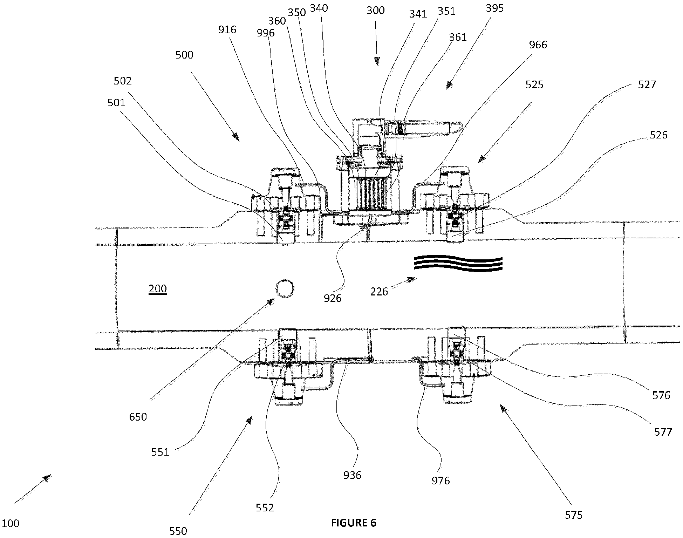

With reference now to Figure 5, a front perspective view of the corrosion sensor configuration of the IMSA 100 of the present invention is provided. The corrosion sensor configuration of the present invention operates in the same manner as the first exemplary embodiment of the IMSA 100 with the exception that the corrosion sensor configuration only comprises: a top of line corrosion sensor 500, a bottom of line corrosion sensor 550, a comparator corrosion sensor 600, a second comparator corrosion sensor 650 (shown in Figure 6), a second top of line corrosion sensor 525, a second bottom of line corrosion sensor 575, a common electronics module 300 and multiple independent means for transferring signals from each device located on the body 200 of the IMSA 100 to the common electronics module 300. The first process rated penetration on the body 200 supports the top of line corrosion sensor 500, the second process rated penetration on the body 200 supports the bottom of line corrosion sensor 550, the third process rated penetration on the body 200 supports the comparator corrosion sensor 600, the fourth process rated penetration on the body 200 supports the second comparator corrosion sensor 650 (shown in Figure 3), the fifth process rated penetration on the body 200 supports the second top of line corrosion sensor 525, and the sixth process rated penetration on the body 200 supports the second bottom of line corrosion sensor 575. The top of line corrosion sensor 500, the bottom of line corrosion sensor 550, the comparator corrosion sensor 600 and corresponding means for transferring measurement signals from the sensors 910, 920, 930, to the common electronics module 300 are identical in location on the body 200 and configuration as in the first exemplary embodiment of the IMSA 100.

The second comparator corrosion sensor 650 is located opposite the comparator corrosion sensor 600 on the body 200. The second comparator corrosion sensor 650 further comprises a sensor head 651 (not visible in any Figure, but identical in configuration as the top of line corrosion sensor 500 except that a sample element that is fully protected from corrosion is present, rather than an unprotected sample element), sensor neck 652 (not visible in any Figure, but identical in configuration as the top of line corrosion sensor 500), sensor flange 655 and sensor housing 660. The sensor housing 660 provides an atmospheric cavity for feeding the second comparator corrosion sensor signal wires 996 (shown in Figure 6) into the high-pressure metal tubing 990. The second comparator corrosion sensor 650 contains a reference and sample element that are protected from corrosion and serves the exact same function as the comparator corrosion sensor 600 in the first exemplary embodiment. The second top of line corrosion sensor 525 is located on the other side of the common electronics module 300 downstream the top of line corrosion sensor 500. The second top of line corrosion sensor 525 further comprises a sensor head 526 (shown in Figure 6), sensor neck 527 (shown in Figure 6), sensor flange 530 and sensor housing 535 and is an Electrical Resistance type sensor. The sensor housing 535 provides an atmospheric cavity for feeding the second top of line corrosion sensor signal wires 966 (shown in Figure 6) into the high-pressure metal tubing 960. The second bottom of line corrosion sensor 575 is located on the other side of the common electronics module 300 downstream the bottom of line corrosion sensor 550. The second bottom of line corrosion sensor 575 further comprises a sensor head 576 (shown in Figure 6), sensor neck 577 (shown in Figure 6), sensor flange 580 and sensor housing 585 and is an Electrical Resistance type sensor. The sensor housing 585 provides an atmospheric cavity for feeding the second bottom of line corrosion sensor signal wires 976 (shown in Figure 6) into the high-pressure metal tubing 970. The second top of line 525 and second bottom of line corrosion sensors 575 have an sample and reference element present, identical to those found in the top of line 500 and bottom of line 550 corrosion sensors in the first exemplary embodiment of the IMSA 100. The comparator corrosion sensor 600 and the second comparator corrosion sensor 650 may be co-located in the same sensor head as the bottom and top line corrosion sensors 500, 550, 525, 575.

With reference now to Figure 6, a cross-section view of the corrosion sensor configuration of the IMSA 100 of the present invention is provided. Figure 6 illustrates the internal workings of the second embodiment corrosion sensor configuration of the IMSA 100 and the third embodiment common electronics module 300. Measurement signals provided by each sensor's transducers on the IMSA 100 are then read via each device's signal wires by each device's individual electronics measurement circuits, where the measurement signals are processed via the individual device processors within the individual electronics measurement circuits. This initially processed data is then communicated via the local internal digital protocol to the active master processor 380. The active master processor 380 then performs additional real-time processing operations on the sensor data to improve data quality and accuracy by comparing, combining, and processing data from all the different sensors in one place. This additionally processed data is then communicated to the network interface electronics 390 for onward transmission to the external control module 310. In an alternative configuration, there is an inactive master processor and an inactive network interface electronics. If either the active master processor 380 or network interface electronics 390 fail, processing and communications can be carried out by the redundant circuits. Furthermore, power and communications will be supplied to the common electronics module 300 from the external control module 310 via jumpers 395 which may be potentially dual redundant.

In an alternative configuration, the individual measurement electronics circuits for each sensor are housed at the sensor location and the common electronics module 300 would then only contain the active master processor 380 and the network interface electronics 390. Furthermore, if the top of line corrosion sensor 500 (second top of line corrosion sensor 525) and comparator corrosion sensor 600 (second comparator corrosion sensor 650) and/or the bottom of line corrosion sensor 550 (second bottom of line corrosion sensor 575) and comparator corrosion sensor 600 (second comparator corrosion sensor 650) are co-located in the same sensor head and the measurement electronics circuits are housed at the sensor location, it may be beneficial to implement a dual channel measurement. Each dual measurement circuit would take measurements for a top or bottom of line corrosion sensor and a comparator sensor which are both located in the same sensor head.

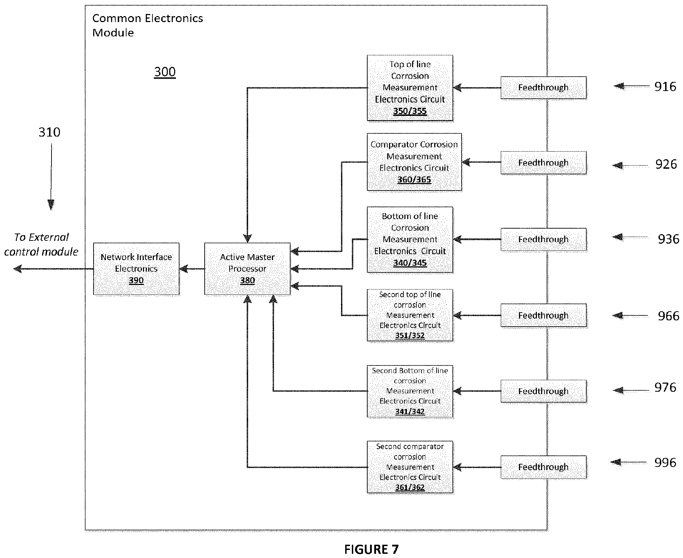

With reference to Figure 7, a circuit diagram demonstrating the inner workings of the second embodiment common electronics module 300 according to the corrosion sensor configuration of the present invention is provided. The common electronics module 300 is identical in its structure and workings as in Figure 4, but houses measurement electronics circuits only for corrosion and comparator corrosion sensors. This diagram illustrates each device's individual feedthrough into the common electronics module 300 via each individual device's signal wires. The top of line corrosion measurement electronics 350 further comprises a top of line corrosion sensor processor 355 receiving excitation and measurement signals via signal wires 916, bottom of line corrosion measurement electronics 340 further comprising a bottom of line corrosion sensor processor 345 receiving excitation and measurement signals via signal wires 936, and comparator corrosion measurement electronics circuit 360 further comprising a comparator corrosion sensor processor 365 receiving excitation and measurement signals via signal wires 926 are identical as in the second embodiment common electronics module 300 according to the first exemplary embodiment of the IMSA 100.

The second comparator corrosion sensor signal wires 996 carry measurement signals provided by the second comparator corrosion sensor head 651, which is passed through the sensor neck 652, and sensor housing 660 (shown in Figure 5). The second comparator corrosion sensor signal wires 996 then connects on a second end to the common electronics module 300 via a feedthrough. The measurement signals are then further passed to the second comparator corrosion measurement electronics circuit 361 which further comprises a second corrosion comparator sensor processor 362 that processes the measurement signals. The second top of line corrosion sensor signal wires 966 carry measurement signals provided by the second top of line corrosion sensor head 526 (shown in Figure 6), which is passed through the sensor neck 527 (shown in Figure 6), and sensor housing 535 (shown in Figure 5). The second top of line corrosion sensor signal wires 966 then connects on a second end to the common electronics module 300 via a feedthrough. The measurement signals are then further passed to the second top of line corrosion measurement electronics circuit 351 which further comprises the second top of line corrosion processor 352 that process the measurement signals. The second bottom of line corrosion sensor signal wires 976 carry measurement signals provided by the second bottom of line corrosion sensor head 576 (shown in Figure 6), which is passed through the sensor neck 577(shown in Figure 6), and sensor housing 585 (shown in Figure 5). The second bottom of line corrosion sensor signal wires 976 then connects on a second end to the common electronics module 300 via a feedthrough. Measurement signals are then passed to the second bottom of line corrosion measurement electronics circuit 341 which further comprises the second bottom of line corrosion processor 342 that processes the measurement signals.

All the further processed data from each active corrosion and comparator corrosion sensor is then communicated via an internal digital protocol to the active master processor 380 which performs additional real-time data processing operations on the sensor data to improve data quality and accuracy by comparing, cross-checking, combining and processing data from the various different sensors. A second inactive master processor may be implemented for redundancy purposes in case the active master processor fails or has complications. This additionally processed sensor data is then communicated to the active network interface electronics 390 for onward transmission to the external control module 310. A second network interface electronics may be included for redundancy and backup purposes if the active network interface electronics

While the invention has been described by reference to certain preferred embodiments, it should be understood that numerous changes could be made within the spirit and scope of the inventive concept described. Also, the present invention is not to be limited in scope by the specific embodiments described herein. It is fully contemplated that other various embodiments of and modifications to the present invention, in addition to those described herein, will become apparent to those of ordinary skill in the art from the foregoing description and accompanying drawings. Thus, such other embodiments and modifications are intended to fall within the scope of the following appended claims. Further, although the present invention has been described herein in the context of particular embodiments and implementations and applications and in particular environments, those of ordinary skill in the art will appreciate that its usefulness is not limited thereto and that the present invention can be beneficially applied in any number of ways and environments for any number of purposes. Accordingly, the claims set forth below should be construed in view of the full breadth and spirit of the present invention as disclosed herein.

## Claims

1. A subsea integrity monitoring spool apparatus for effective monitoring, cross-checking, and measuring data of flow-lines or pipelines from a plurality of different sensors to process data in real-time, the apparatus comprising:
a body portion comprising first and second body portion ends, a longitudinal section for carrying process fluids and extending between said ends, and a plurality of process-rated penetrations for mounting intrusive sensors;
a first corrosion sensor mounted on the body portion at a first process-rated penetration and adapted to generate measurement signals indicative of corrosion of the body portion, the first corrosion sensor comprising:
a sample element not protected from corrosion and in fluid communication with process fluids carried through the body, the sample element adapted to measure corrosion; and
a reference element protected from corrosion, the reference element utilized as a reference of corrosion measurement to the sample element; and
a comparator corrosion sensor mounted on the body portion at a second nearby process-rated penetration and adapted to generate measurement signals resulting from process-related effects, the comparator corrosion sensor comprising a sample element and a reference element, the reference element and sample element being fully protected from corrosion.

2. The subsea integrity monitoring spool apparatus of claim 1, wherein the process-rated penetrations for mounting intrusive sensors are configured to support a top of line corrosion sensor, a bottom of line corrosion sensor, a comparator corrosion sensor, a pressure and temperature sensor, and an erosion sensor.

3. The subsea integrity monitoring spool apparatus of claim 1, further comprising a passive non-intrusive acoustic sand detector mounted on the body portion and configured to measure acoustic signals generated by particles flowing in the process fluids and for particle sizing by comparing with an erosion sensor output.

4. The subsea integrity monitoring spool apparatus of claim 1, wherein the sample element and the reference element of the comparator corrosion sensor are housed in a same head as the sample element and reference element of the first corrosion sensor.

5. The subsea integrity monitoring spool apparatus of claim 1, wherein a sample element and a reference element of a comparator erosion sensor are housed in a same head as the sample element and reference element of a first erosion sensor.

6. The subsea integrity monitoring spool apparatus of claim 1, wherein each of the intrusive sensors are configured with a single or a dual barrier to process pressure, the single or dual barrier comprising a penetrator to permit electrical signals to pass through.

7. The subsea integrity monitoring spool apparatus of claim 1, wherein the body portion comprises a Venturi profile adapted to improve consistency of sensor performance as process conditions change over time, the Venturi profile comprising:
a throat comprising a first erosion sensor, the throat adapted to maximize erosion rate on the first erosion sensor;
a convergent body section with a decreasing diameter adapted to increase particle velocity inside the process fluids, the convergent body section disposed upstream of the throat; and
a divergent body section with an increasing diameter adapted to decrease particle velocity inside the process fluids, the divergent body section disposed downstream of the throat.

8. The subsea integrity monitoring spool apparatus of claim 7, further comprising a second erosion sensor whereby first and second erosion rates associated respectively with the first and second erosion sensors are compared to qualitatively assess particle size or changes in particle size, the second erosion sensor not located within the throat and being active with its sample element exposed to erosion.

9. The subsea integrity monitoring spool apparatus of claim 1, further comprising a common electronics module having intelligent processing to process at least the measurement signals indicative of corrosion of the body portion generated by the first corrosion sensor and the measurement signals resulting from process-related effects generated by the comparator corrosion sensor and adapted to transmit the processed measurement signals representing corrosion of the body portion and compensated for process-related effects to an external control module.

10. A subsea integrity monitoring spool apparatus for effective monitoring, cross-checking, and measuring data of flow-lines or pipelines from a plurality of different sensors to process data in real-time, the apparatus comprising:
a body portion comprising first and second body portion ends, a longitudinal section for carrying process fluids and extending between said ends, and a plurality of process-rated penetrations for mounting intrusive sensors;
a common electronics module having intelligent processing, the common electronics module comprising:
a housing mounted on the body portion adapted to carry process fluids and comprising a plurality of process-rated penetrations for mounting intrusive sensors;
an active master processor disposed within the housing and comprising an input adapted to receive a plurality of signals derived from a plurality of measurement signals generated respectively by a plurality of sensors mounted at respective penetrations of the plurality of process-rated penetrations, the active master processor adapted to perform, based at least in part on the plurality of received signals, one or more of the following set of operations: comparing data; cross-checking data; combining data; and automatically calculating revised sensor coefficients, the active master processor adapted to output a set of signals related to monitored conditions at the subsea equipment monitoring apparatus;
wherein the plurality of measurement signals includes: a signal from an active corrosion sensor; at least one signal generated by a sample element not protected from corrosion and in fluid communication with process fluids carried through the body portion, the sample element adapted to measure corrosion; and at least one signal generated by a reference element protected from corrosion and being adapted to measure corrosion.

11. The subsea integrity monitoring spool apparatus of claim 10, wherein the housing further comprises feedthroughs for the plurality of measurement signals generated respectively by the plurality of sensors mounted at respective penetrations of the plurality of process-rated penetrations, the feedthroughs adapted to communicate the plurality of measurement signals to a plurality of independent sensor-specific measurement electronics circuits, each of the plurality of independent sensor-specific measurement electronics circuits comprising an independent sensor-specific processor adapted to process received measurement signals.

12. The subsea integrity monitoring spool apparatus of claim 10, wherein the active master processor is adapted to receive signals derived from a top of line corrosion sensor, a bottom of line corrosion sensor; a comparator corrosion sensor; a pressure and temperature sensor; and an erosion sensor; the comparator corrosion sensor comprising a sample element and a reference element, the reference and sample elements being fully protected from corrosion and adapted to generate measurement signals representing process-related effects of the process fluids, the top of line corrosion sensor and bottom of line corrosion sensor adapted to measure corrosion and comprising an sample element not protected from corrosion and in fluid communication with process fluids carried through the body portion, the sample element adapted to measure corrosion and a reference element protected from corrosion, the reference element utilized as a reference of measurement to the sample element.

13. The subsea integrity monitoring spool apparatus of claim 10, wherein the active master processor is adapted to receive signals derived from a passive non-intrusive acoustic sand detector configured to measure acoustic signals generated by particles flowing in the process fluids, the acoustic signals communicated through a feedthrough, on the housing, to an independent sensor-specific measurement electronics circuits comprising an independent sensor-specific processor adapted to process the acoustic signals generated by the acoustic sand detector.

14. The subsea integrity monitoring spool apparatus of claim 10, wherein the active master processor is adapted to receive signals derived from a first erosion sensor disposed within a throat of a Venturi profile to provide an early warning when erosion rates start to increase.

15. The subsea integrity monitoring spool apparatus of claim 14, further comprising a second erosion sensor whereby first and second erosion rates associated respectively with the first and second erosion sensors are compared to qualitatively assess particle size or changes in particle size, the second erosion sensor not located within the throat and being active with its sample element exposed to erosion.

16. The subsea integrity monitoring spool apparatus of claim 10, wherein the set of signals related to monitored conditions at the subsea equipment monitoring apparatus are communicated to an active network interface adapted to communicate the set of signals related to monitored conditions at the subsea equipment monitoring apparatus onward to a subsea external control module.

17. A method for enhanced compensation of Electrical Resistance type sensors in a subsea environment, the method comprising:
fully protecting a sample element and a reference element of a comparator sensor so the sample element and the reference element are not susceptible to corrosion or erosion;
exposing the sample element and the reference element of the comparator sensor to process-related effects in the process environment;
measuring the process-related effects on the sample element and the reference element of the comparator sensor to generate a comparator sensor measurement signal resulting from the process-related effects;
comparing the comparator sensor measurement signal to an active sensor measurement signal and accounting for the effect of the process-related effects on the sample element and the reference element of the comparator sensor in the active sensor measurement signal, the active sensor measurement signal derived from the effect of a electrochemical or mechanical action on a sample element and a reference element of the active sensor, the sample element of the active sensor configured to be susceptible to process conditions and the reference element of the active sensor configured to be protected from process conditions; and
generating a better compensated reading by analyzing the comparator sensor measurement signal and the active sensor measurement signal to determine whether the effects on the active sensor is a process event or a genuine effect of metal loss.

18. The method for enhanced compensation of Electrical Resistance type sensors in a subsea environment of claim 17 wherein the active sensor is an erosion sensor or a corrosion sensor and the comparator sensor is a comparator corrosion sensor or a comparator erosion sensor.
